(19) **Europäisches Patentamt / European Patent Office / Office européen des brevets**

(11) **EP 3 916 790 A1**

(12) **EUROPEAN PATENT APPLICATION**
published in accordance with Art. 153(4) EPC

(43) Date of publication:
01.12.2021 Bulletin 2021/48

(21) Application number: 20749755.3

(22) Date of filing: 20.01.2020

(51) Int Cl.:
$H01L\ 27/32^{(2006.01)}$   $G09F\ 9/33^{(2006.01)}$

(86) International application number:
PCT/CN2020/073149

(87) International publication number:
WO 2020/156309 (06.08.2020 Gazette 2020/32)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 01.02.2019 CN 201910107751

(71) Applicant: GUANGDONG OPPO MOBILE TELECOMMUNICATIONS CORP., LTD.
Dongguan, Guangdong 523860 (CN)

(72) Inventor: YUAN, Shilin
Dongguan, Guangdong 523860 (CN)

(74) Representative: Ipside
7-9 Allées Haussmann
33300 Bordeaux Cedex (FR)

(54) **ELECTRONIC APPARATUS, PIXEL STRUCTURE, AND DISPLAY DEVICE**

(57) Embodiments of the present application provide an electronic apparatus, a pixel structure, and a display device. The display device of the electronic apparatus comprises: two pixel apertures adjacently disposed in a first direction at a first spacing; two pixel apertures adjacently disposed in a second direction at a second spacing; and an organic light-emitting member having a first measurement in the first direction and a second measurement in the second direction, wherein the first measurement is not equal to the first spacing, and the second measurement is not equal to the second spacing. A camera module collects images by means of the display device.

FIG. 2

EP 3 916 790 A1

Printed by Jouve, 75001 PARIS (FR)

## Description

The present application claims a Chinese Patent Application No. 201910107751.6, filed on February 01, 2019, in the title of "Electronic Device, Pixel Structure and Display Apparatus", and the entire contents of which are hereby incorporated by reference in their entireties.

## TECHNICAL FIELD

The present disclosure relates to the field of electronics, and in particular to an electronic device, a pixel structure, and a display apparatus.

## BACKGROUND

With the development of communication technology, electronic devices such as smart phones are becoming more and more popular. While using electronic devices, electronic devices may take their displays to display images.

## SUMMARY OF THE DISCLOSURE

The present disclosure may provide an electronic device, a pixel structure and a display apparatus, reducing diffraction interference.

Embodiments of the present disclosure provide an electronic device, including a display apparatus and a camera module. The display apparatus may include following components.

A pixel-defining layer is arranged and defines a plurality of pixel holes arranged in an array. A first spacing is defined between two adjacent pixel holes of the plurality of pixel holes along a first direction, and a second spacing is defined between two adjacent pixel holes of the plurality of pixel holes along a second direction.

An organic light emitting layer is arranged and includes a plurality of organic light emitters. Each of the plurality of organic light emitters is received in one of the plurality of pixel holes, each of the plurality of organic light emitters has a first size in the first direction and a second size in the second direction.

The first direction is perpendicular to the second direction, the first size is different from the first spacing, and the second size is different from the second spacing.

At least a part of the camera module is disposed opposite to the pixel holes, and the camera module is configured to capture images through the display apparatus.

Embodiments of the present disclosure provide a pixel structure, including following components.

A pixel-defining layer is arranged and defines a plurality of pixel holes arranged in an array. A first spacing is defined between two adjacent pixel holes of the plurality of pixel holes along a first direction, and a second spacing is defined between two adjacent pixel holes of the plurality of pixel holes along a second direction.

An organic light emitting layer is arranged and includes a plurality of organic light emitters. Each of the plurality of organic light emitters is received in one of the plurality of pixel holes, each of the plurality of organic light emitters has a first size in the first direction and a second size in the second direction.

The first direction is perpendicular to the second direction, the first size is different from the first spacing, and the second size is different from the second spacing.

Embodiments of the present disclosure provide a display apparatus, including following components.

A pixel-defining layer is arranged and defines a plurality of pixel holes arranged in an array. A first spacing is defined between two adjacent pixel holes of the plurality of pixel holes along a first direction, and a second spacing is defined between two adjacent pixel holes of the plurality of pixel holes along a second direction.

An organic light emitting layer is arranged and includes a plurality of organic light emitters, wherein each of the plurality of organic light emitters is received in one of the plurality of pixel holes, each of the plurality of organic light emitters has a first size in the first direction and a second size in the second direction.

The first direction is perpendicular to the second direction, the first size is different from the first spacing, and the second size is different from the second spacing.

Embodiments of the present disclosure provide a display apparatus, including a first display panel and a second display panel.

The first display panel defines a notch, the notch extends through the first display panel along a thickness direction of the first display panel. The second display panel is received in the notch.

A pixel structure of the second display panel includes following components.

A pixel-defining layer is arranged and defines a plurality of pixel holes arranged in an array. A first spacing is defined between two adjacent pixel holes of the plurality of pixel holes along a first direction, and a second spacing is defined between two adjacent pixel holes of the plurality of pixel holes along a second direction.

An organic light emitting layer is arranged and includes a plurality of organic light emitters. Each of the plurality of organic light emitters is received in one of the plurality of pixel holes, each of the plurality of organic light emitters has a first size in the first direction and a second size in the second direction.

The first direction is perpendicular to the second direction, the first size is different from the first spacing, and the second size is different from the second spacing.

**BRIEF DESCRIPTION OF THE DRAWINGS**

In order to illustrate technical solutions of embodiments of the present disclosure more clearly, accompanying drawings for describing the embodiments will be briefly introduced.

FIG. 1 is a structural schematic view of an electronic device according to an embodiment of the present disclosure.
FIG. 2 is a schematic view of a pixel structure of a transparent region of an electronic device according to an embodiment of the present disclosure.
FIG. 3 is another schematic view of a pixel structure of a transparent region of an electronic device according to an embodiment of the present disclosure.
FIG. 4 is a diagram of far-field diffraction intensity of a pixel structure in a transparent region of an electronic device according to an embodiment of the present disclosure.
FIG. 5 is a diagram of a far-field diffraction intensity envelope of a pixel structure in a transparent region of an electronic device according to an embodiment of the present disclosure.
FIG. 6 is a diagram of a one-dimensional diffraction order spacing of a pixel structure in a transparent region of an electronic device according to an embodiment of the present disclosure.
FIG. 7 is a diagram of a far-field diffraction intensity of a light spot of a pixel structure in a transparent region of an electronic device according to an embodiment of the present disclosure.
FIGS. 8a - 8k are diagrams of intensity envelopes and diffraction order distribution of diffraction patterns of a pixel structure according to an embodiment of the present disclosure.
FIGS. 9a - 9h are other diagrams of intensity envelopes and diffraction order distribution of diffraction patterns of a pixel structure of a transparent region of an electronic device according to an embodiment of the present disclosure.
FIG. 10 is a diagram of energy distribution of a pixel structure of a transparent region of an electronic device, while a periodic unit spacing is varying, according to an embodiment of the present disclosure.
FIG. 11 is another schematic view of a pixel structure of a transparent region of an electronic device according to an embodiment of the present disclosure.
FIG. 12 is a cross-sectional view of a transparent region of an electronic device according to an embodiment of the present disclosure.
FIG. 13 is another cross-sectional view of a transparent region of an electronic device according to an embodiment of the present disclosure.
FIG. 14 is still another cross-sectional view of a transparent region of an electronic device according to an embodiment of the present disclosure.
FIG. 15 is yet another cross-sectional view of a transparent region of an electronic device according to an embodiment of the present disclosure.
FIG. 16 is another schematic view of an electronic device according to an embodiment of the present disclosure.
FIG. 17 is a schematic view of pixel layers of an electronic device according to an embodiment of the present disclosure.
FIG. 18 is still another schematic view of an electronic device according to an embodiment of the present disclosure.

**DETAILED DESCRIPTION**

Technical solutions in the embodiments of the present disclosure will be clearly and completely described below by referring to the accompanying drawings. Obviously, the described embodiments are only a part of, but not all of, the embodiments of the present disclosure. Based on the embodiments in the present disclosure, all other embodiments obtained by skilled persons in the art without creative work shall fall within the scope of the present disclosure.

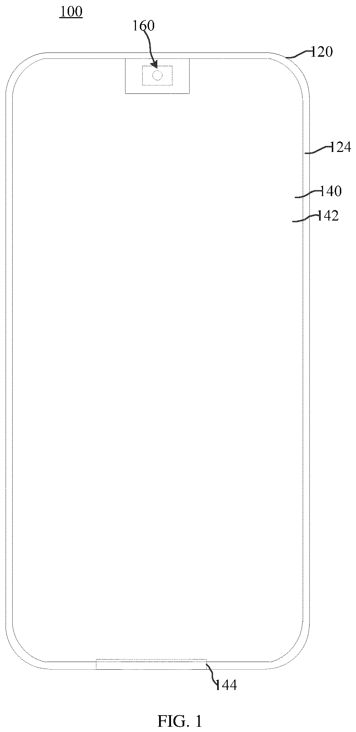

As shown in FIG. 1, an electronic device 100 may include a shell 120, a display apparatus 140 and a camera module 160. The display apparatus 140 may include a display panel 142 and a drive circuit 144. The drive circuit 144 may drive the display panel 142 to display various images. The display apparatus 140 may be disposed on the shell 120. The shell 120 may include a back cover and a side frame 124, and the side frame 124 may be configured to surround a circumference of the back cover. The display apparatus 140 may be disposed inside the side frame 124. The display apparatus 140 and the back cover may serve as two opposite sides of the electronic device 100. The camera module 160 may be disposed between the back cover of the shell 120 and the display apparatus 140. It may be understood that, the camera module 160 may include an image acquisition surface for acquiring an image, and the display apparatus 140 may include a display surface and a display back face opposite to the display surface. The image acquisition surface of the camera module 160 may face the display back face of the display apparatus 140. The camera module 160 may acquire a light signal that passes through the display apparatus 140, and an image may be obtained based on the acquired light signal. In some embodiments, the camera module 160 may serve as a front camera of the electronic device 100. The camera module 160 may acquire an image such as a selfie of a user through the display apparatus 140.

In the related art, in order to obtain a larger screen-to-body ratio, the camera module of the electronic device may be disposed under a display screen. The camera module may acquire the light signal that passes through the display screen to generate an image under the display screen. However, a periodic pixel arrangement structure may be configured in the display screen. The periodic pixel arrangement may generate diffraction interference while the camera module is generating an image, such that quality of generating the image under the display screen may be reduced.

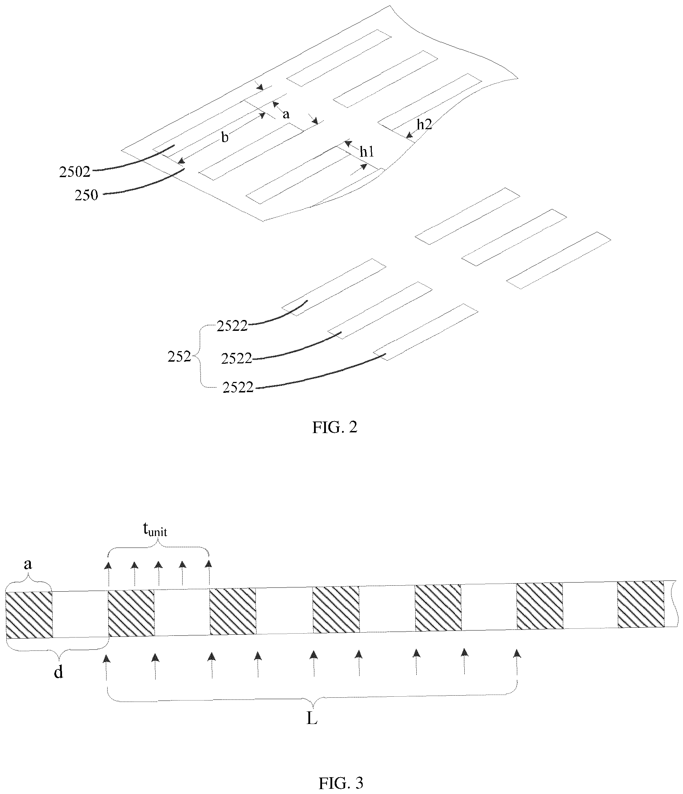

As shown in FIG. 2, the display apparatus of the electronic device may include a pixel-defining layer 250 and an organic light emitting layer 252. The pixel-defining layer 250 may define a plurality of pixel holes 2502 arranged in an array. There may be a first spacing h1 between two adjacent pixel holes 2502 in a first direction and a second spacing h2 between two adjacent pixel holes 2502 in a second direction.

The organic light emitting layer 252 may include a plurality of organic light emitters 2522. Each of the plurality of organic light emitters 2522 is correspondingly received in one of the plurality of pixel holes 2502. Each organic light emitter 2522 has a first size a in the first direction and a second size b in the second direction.

The first direction is perpendicular to the second direction, the first size a may not be equal to the first spacing h1, and the second size b may not be equal to the second spacing h2.

In the first direction, the first size a of the organic light emitter 2522 may not be equal to the first spacing h1 between the two adjacent pixel holes 2502. In the second direction, the second size b of the organic light emitter 2522 may not be equal to the second spacing h2 between the two adjacent pixel holes 2502. According to the present embodiment, the diffraction effect on the light signal passing through the pixel structure may be reduced.

The plurality of pixel holes 2502 are arranged in an array. The plurality of pixel holes 2502 arranged in an array may include a plurality of columns of pixel holes 2502 and a plurality of rows of pixel holes 2502, the plurality of columns are parallel to each other, and the plurality of rows are parallel to each other. The first direction may be interpreted as a row direction of the array, and the second direction may be interpreted as a column direction of the array. Alternatively, the first direction may be interpreted as the column direction of the array, and the second direction may be interpreted as the row direction of the array.

The pixel holes 2502 and the organic light emitters 2522 in the pixel structure are periodic structures. For understanding, a one-dimensional structure may be taken as an example. As shown in FIG. 3, a Fourier transform relationship is formed between a transmittance function of the pixel structure and a far-field diffracted light intensity. It may be assumed that the transmittance function of each periodic unit is $t_{unit}(x)$, a width of the periodic unit is d, and each periodic unit is composed of two materials. A width of a first material (i.e., the organic light emitter 2522) is a, and a width of a second material (i.e., pixel-defining layer 250) is d-a. The transmittance function of the one-dimensional pixel structure may be expressed as:

$$t(x) = t_{unit}(x) \otimes \frac{1}{d} comb\left(\frac{x}{d}\right) \qquad (1)$$

The $\otimes$ is a convolution sign, and the comb(x) is a one-dimensional comb function. If a plane wave having a total width of L is applied for irradiation, the light field distribution of the pixel structure may be expressed as:

$$T(x) = [t_{unit}(x) \otimes \frac{1}{d} comb\left(\frac{x}{d}\right)] \cdot rect\left(\frac{x}{L}\right) \qquad (2)$$

Fourier transformation may be performed on the equation (2) to obtain the far-field diffracted light field distribution, shown as follows:

$$E(x) = FT\{T(x)\}$$

$$= \frac{1}{L}[FT\{t_{unit}(x)\} \cdot comb(dx)] \cdot sinc(Lx) \qquad (3)$$

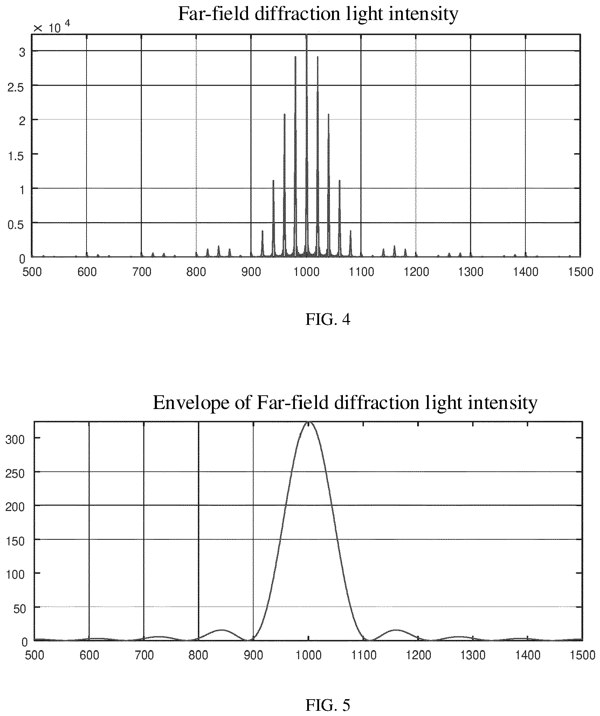

As shown in FIG. 4, FIG. 4 shows the far-field diffracted light field distribution for $t_{unit}(x) = rect(x/a)$, which may be interpreted as only two components, a transparent component and a non-transparent component, being present. For understanding, a constant term may be ignored, and the far-field diffraction pattern may be composed of three components.

A first component, as shown in FIG. 5, may be Fourier transform of the transmittance function of the periodic unit FT{$t_{unit}(x)$}. The first component may form an envelope of an entirety of the diffracted light intensity. A shape of the envelope may be related to the transmittance function $t_{unit}(x)$ of the periodic unit (since the width of $t_{unit}(x)$ is d, the shape may further be related to the spacing d).

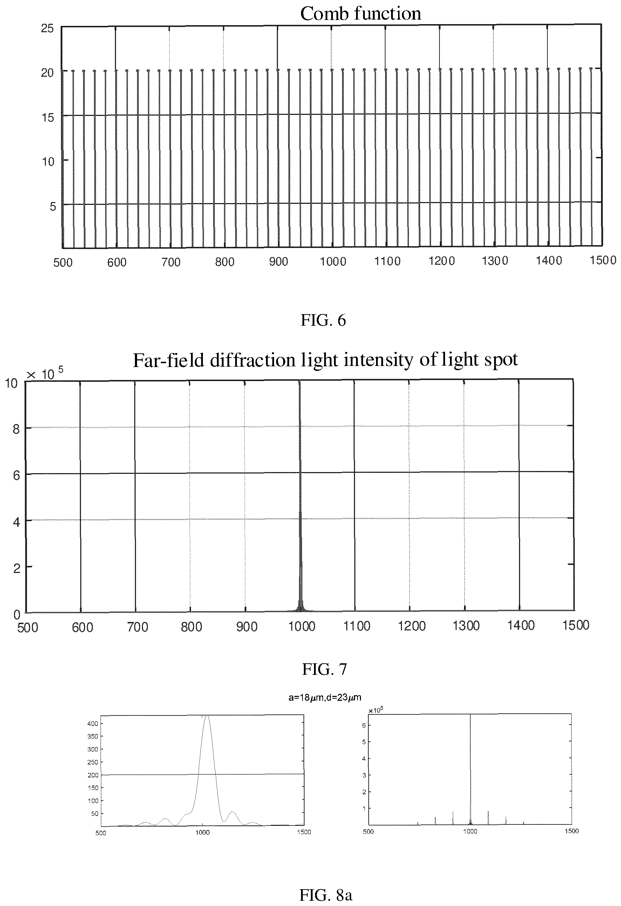

A second component, as shown in FIG. 6, may be the comb function comb(dx). The second component may determine the spacing between diffraction orders. A value of the comb function may be related to the spacing d of the periodic unit only.

A third component, as shown in FIG. 7, may be the Fourier transform of the light spot sinc(Lx). The third component may determine a size and a shape of each diffracted light spot. A value of the Fourier transform of the light spot sinc(Lx) may be related to a diameter L of the light spot only.

Based on MATLAB simulation and experimental test data, it may be determined that the diffraction order spacing and d are inversely proportional. When the d increases, the diffraction order spacing may be gradually reduced. When a ratio of a to d is close to a=0.5d, diffracted light intensity of orders of $\pm1$ may be strongest, that is, the $\frac{I_{\pm1}}{I_0}$ may reach a maximum value.

In the MATLAB simulation, an initial structure may have a $\lambda$ = 630nm, a refractive index of a material 1 n1=1.79, a thickness d1=0.3$\mu$m, a refractive index of a material 2 n1=1.64, a thickness d2=1.6$\mu$m, a width of the material 1 a=18$\mu$m, and a periodic unit size d=43$\mu$m, and the transmittance function may be expressed as follows.

$$t_{unit}(x)=\begin{pmatrix} \exp\left[i\frac{2\pi}{\lambda}\cdot(n_1 d_1 + n_0(d_2 - d_1))\right], & 0<x\leq a \\ \exp\left[i\frac{2\pi}{\lambda}\cdot(n_2 d_2)\right], & a<x<d \end{pmatrix} \qquad (4)$$

The diffraction intensity distribution may be observed by varying values for a and d respectively.

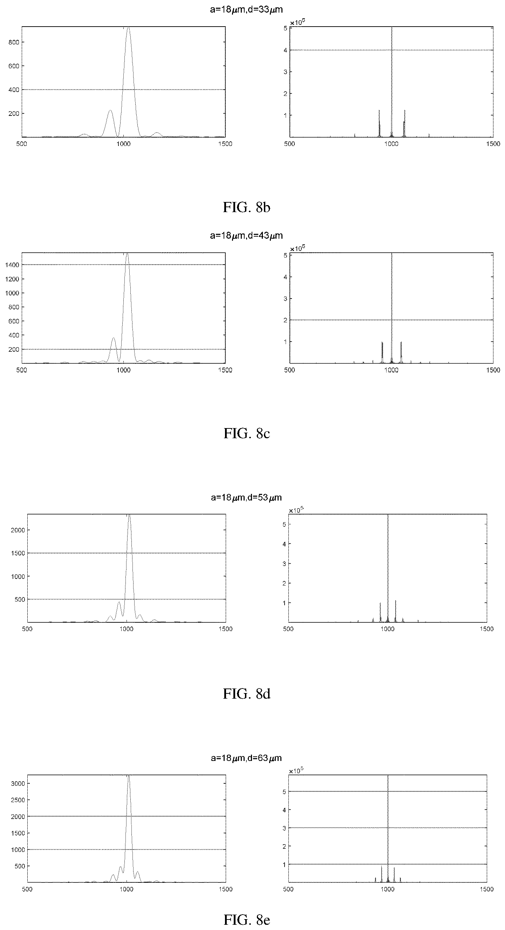

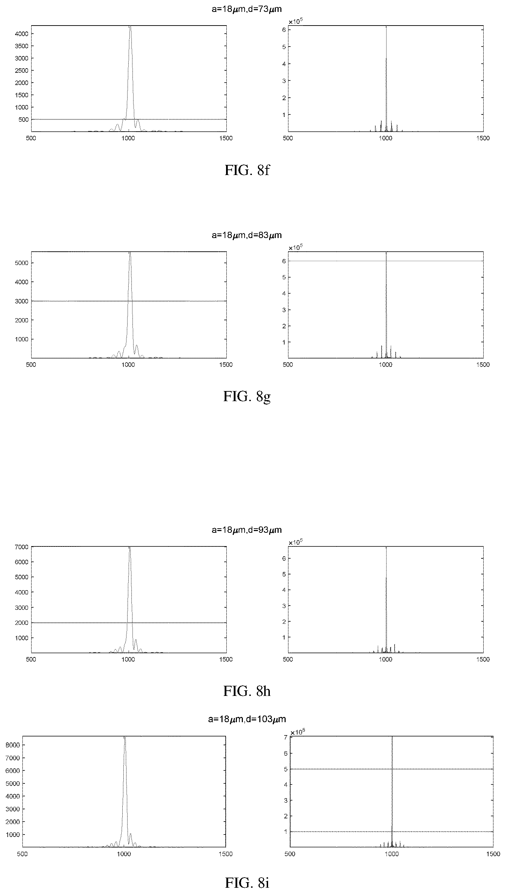

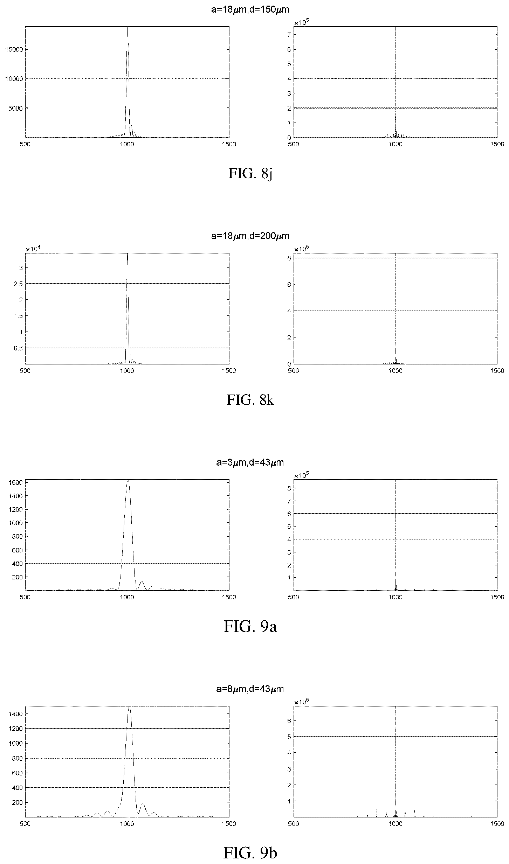

The d value may be changed, and the width of the rectangular pixel hole 2502 may be fixed to be a=18$\mu$m. The pixel hole 2502 may be rectangular. The pixel hole 2502 has the first size a in the first direction and the second size b in the second direction. It may also be understood that a width of a short side of the rectangular pixel hole 2502 is the first size a, and a length of a long side is the second size b. The d value may be a distance between two adjacent rectangular pixel holes 2502 along the first direction. The d value may be in a range of 23$\mu$m to 200$\mu$m. The light intensity envelope and diffraction order distribution of the diffraction pattern may be obtained based on various d values. As shown in FIGS. 8a - 8k, FIG. 8a shows the light intensity envelope and diffraction intensity of the diffraction pattern when a=18$\mu$m, and d=23$\mu$m; FIG. 8b shows the light intensity envelope and diffraction intensity of the diffraction pattern when a=18$\mu$m, and d=33$\mu$m; FIG. 8c shows the light intensity envelope and diffraction intensity of the diffraction pattern when a=18$\mu$m, and d=43$\mu$m; FIG. 8d shows the light intensity envelope and diffraction intensity of the diffraction pattern when a=18$\mu$m, and d=53$\mu$m; FIG. 8e shows the light intensity envelope and diffraction intensity of the diffraction pattern when a=18$\mu$m, and d=63$\mu$m; FIG. 8f shows the light intensity envelope and diffraction intensity of the diffraction pattern when a=18$\mu$m, and d=73$\mu$m; FIG. 8g shows the light intensity envelope and diffraction intensity of the diffraction pattern when a=18$\mu$m, and d=83$\mu$m; FIG. 8h shows the light intensity envelope and diffraction intensity of the diffraction pattern when a=18$\mu$m, and d=93$\mu$m; FIG. 8i shows the light intensity envelope and diffraction intensity of the diffraction pattern when a=18$\mu$m, and d=103$\mu$m; FIG. 8j shows the light intensity envelope and diffraction intensity of the diffraction pattern when a=18$\mu$m, and d=150$\mu$m; FIG. 8k shows the light intensity envelope and diffraction intensity of the diffraction pattern when a=18$\mu$m, and d=200$\mu$m. A left figure in each of the FIGS. 8a-8k shows the envelope of the diffracted light intensity. A right figure in each of the FIGS. 8a-8k shows the diffracted light intensity.

It can be seen that, the diffraction order spacing and the d value are inversely proportional. When the d value increases, the diffraction order spacing may be gradually reduced. When the ratio of a to d is approaching to a=0.5d, the diffracted light intensity of the orders of $\pm1$ may be the strongest, that is, the $\frac{I_{\pm1}}{I_0}$ may reach the maximum value.

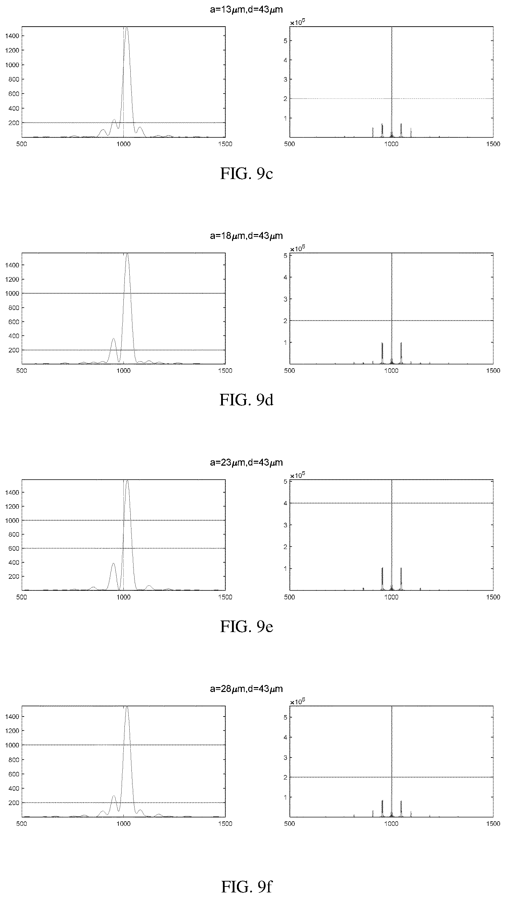

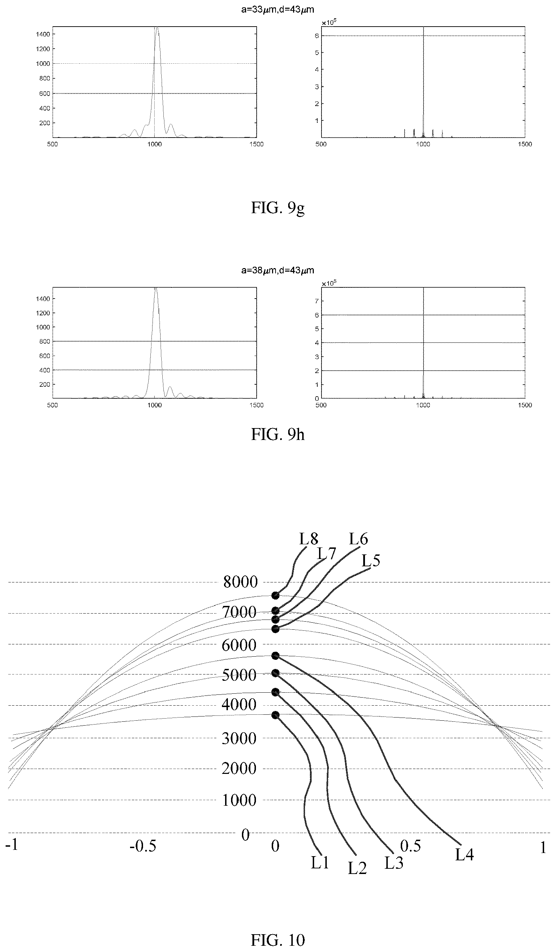

The value of a may be varied, and a total width of the period unit d may be fixed to be 43$\mu$m. The a value may be in a range of 3$\mu$m to 38$\mu$m. The light intensity envelope and diffraction order distribution of the diffraction pattern may be obtained based on various a values. As shown in FIGS. 9a-9h, FIG. 9a shows the light intensity envelope and diffraction intensity of the diffraction pattern when a=3$\mu$m, and d=43$\mu$m; FIG. 9b shows the light intensity envelope and diffraction intensity of the diffraction pattern when a=8$\mu$m, and d=43$\mu$m; FIG. 9c shows the light intensity envelope and diffraction intensity of the diffraction pattern when a=13$\mu$m, and d=43$\mu$m; FIG. 9d shows the light intensity envelope and diffraction intensity of the diffraction pattern when a=18μm, and d=43μm; FIG. 9e shows the light intensity envelope and diffraction intensity of the diffraction pattern when a=23μm, and d=43μm; FIG. 9f shows the light intensity envelope and diffraction intensity of the diffraction pattern when a=28μm, and d=43μm; FIG. 9g shows the light intensity envelope and diffraction intensity of the diffraction pattern when a=33μm, and d=43μm; FIG. 9h shows the light intensity envelope and diffraction intensity of the diffraction pattern when a=38μm, and d=43μm. A left figure in each of the FIGS. 9a - 9h shows the envelope of the diffracted light intensity. A right figure in each of the FIGS. 9a - 9h shows the diffracted light intensity.

It can be seen that, the diffraction order spacing may not be changed when the a value is varying. Similarly, when the ratio of a to d is approaching to a=0.5d, the diffracted light intensity of the orders of ±1 may be the strongest, that is, the $\frac{I_{\pm 1}}{I_0}$ may reach the maximum value.

Since the organic light emitting layer and the pixel-defining layer may be main causes of a ghosting image, the organic light emitting layer and the pixel-defining layer may be simulated (e.g., zemax simulation) to observe a change in the diffraction order when a microstructure of a period unit spacing is varied.

When the periodic unit length of the organic light emitting layer and the pixel-defining layer gradually increases from 43um to 78um by taking 5um as a spacing, relative values of the light intensity in an order of +1, the light intensity in an order of -1, and the light intensity in an order of 0 are shown in Table 1. The first size of the pixel hole a may remain unchanged, and the first spacing d may increase. Energy of higher orders outside the orders of +1 and -1 may always be less than 10% of the energy at the order of 0, and the diffracted light intensity at the order of +1 and the diffracted light intensity at the order of -1 are the main causes for the ghosting image. Therefore, in the present experiment, the order of +1, the order of -1, and the order 0 may be analyzed in detail, which may be shown in Table 1.

Table 1

| Spacing (μm) | Intensity at the order of -1, relative position | Intensity at the order of 0, relative position | Intensity at the order of +1, relative position |
|---|---|---|---|
| 43 | 3195, -0.14 | 3733, 0 | 3195, 0.14 |
| 48 | 2911, -0.13 | 4487, 0 | 2848, 0.13 |
| 53 | 2629, -0.12 | 5068, 0 | 2629, 0.12 |
| 58 | 2323, -0.11 | 5619, 0 | 2303, 0.11 |
| 63 | 2000, -0.10 | 6496, 0 | 2023, 0.10 |
| 68 | 1811, -0.093 | 6743, 0 | 1750, 0.093 |
| 73 | 1656, -0.087 | 6967, 0 | 1646, 0.087 |
| 78 | 1379, -0.08 | 7504, 0 | 1390, 0.08 |

As shown in FIG. 10, FIG. 10 shows the energy distribution when the periodic unit length of the organic light emitting layer and the pixel-defining layer is varied. A curve L1 may correspond to an spacing of 43um; a curve of L2 may correspond to an spacing of 48um; a curve of L3 may correspond to an spacing of 53um; a curve of L4 may correspond to an spacing of 58um; a curve of L5 may correspond to an spacing of 63um; a curve of L6 may correspond to an spacing of 68um; a curve of L7 may correspond to an spacing of 73um; and a curve of L8 may correspond to an spacing of 78um. It can be seen from figure, when the spacing between the organic light emitters of the organic light emitting layer increases, the relative position between the diffraction orders may gradually approach to the order of 0 (the main diffraction order). While generating the image, a ghosting part of the image may tend to overlap with a main part of the image.

At the same time, as the spacing between the organic light emitters increases, the intensity of the order of 0 may be gradually enhanced, and the intensity of the orders of ± 1 may be gradually weakened. When the periodic unit length is 78um and is equal to a GFF spacing, the intensity of the main diffraction order may reach a maximum, and the intensity of the orders of +1 and -1 may reach a minimum.

As the spacing between the organic light emitters increases, each diffraction order may approach to a middle and the spacing between diffraction orders may be decreased. The light intensity of the orders of +1 and -1 may be reduced, but the light intensity of a higher order may be gradually enhanced. Therefore, along the first direction, the greater the difference between the first size a of the organic light emitter and the spacing h1 between two adjacent pixel holes, the weaker the diffraction.

As shown in FIG. 2, in some embodiments, the first size a of the organic light emitter 2522 may be less than the second size b of the organic light emitter 2522, and the second size b may not be equal to the first spacing h1.

The organic light emitter 2522 may be in a shape of a strip and have a along side and a short side. The short side may correspond to the first size a, and the long side may correspond to the second size b. The second side b of the organic light emitter 2522 may not be equal to the first spacing h1. The organic light emitter 2522 may be rectangular or in other shapes.

It should be noted that, the first spacing h1 is the distance between two adjacent pixel holes in the first direction of the pixel-defining layer. The organic light emitters may be received in the pixel holes correspondingly. Therefore, the first spacing h1 may also be understood as the distance between two adjacent organic light emitters in the first direction of the organic light emitting layer. Similarly, the second spacing h2 may also be understood as the distance between two adjacent organic light emitters in the second direction of the organic light emitting layer.

In some embodiments, the first size a of the organic light emitter 2522 may be less than the first spacing h1, and the second size b may be greater than the first spacing h1.

In the first direction, the first spacing h1 between two adjacent pixel holes 2502 may be greater than the first size a of the organic light emitter 2522. Generally, the sizes of the organic light emitter 2522 may be fixed, and therefore, the spacing between two adjacent pixel holes 2502 may be increased, such that the first size a may be less than the first spacing h1. The second size b of the organic light emitter 2522 may also be greater than the first spacing h1, and the first spacing h1 may be greater than the first size a. It should be understood that the organic light emitter 2522 may be strip-structured, such as in a shape of a rectangle, and the like.

In some embodiments, the first size a of the organic light emitter 2522 may be less than the second size b, and the first size a may be greater than the first spacing h1.

In the first direction, the first size a of the organic emitter 2522 may be greater than the first spacing h1 between two adjacent pixel holes 2502, such that the diffraction effect of the light signal that passes through the pixel structure may be reduced.

In some embodiments, each pixel hole may be squared, and the organic light emitter received in the pixel hole may also be squared. The first size a of the organic light emitter in the first direction may be equal to the second size b of the organic light emitter in the second direction. In the first direction, the first size a of the organic light emitter may be greater or less than the first spacing h1 between the two adjacent pixel holes. In the second direction, the second size b of the organic light emitter may be greater or less than the second spacing h2 between the two adjacent pixel holes. The first spacing h1 and the second spacing h2 may be equal or unequal. The first spacing h1 may be greater or less than the second spacing h2. In this way, the diffraction effect of the light signal that passes through the pixel structure may be reduced.

It should be noted that, the greater the difference between the first size a of the organic light emitter 2522 and the first spacing h1, the more the diffraction effect of the light signal passing through the pixel structure may be reduced. The larger the difference between the second size b and the second spacing h2, the more the diffraction effect of the light signal passing through the pixel structure may be reduced.

In some embodiments, each pixel hole 2502 may be rectangular, and the organic light emitter 2522 received in the pixel hole 2502 may be rectangular correspondingly. The first direction may be understood as the row direction of the array or a direction parallel to the short side of the pixel hole 2502. The second direction may be understood as the column direction of the array or a direction parallel to the long side of the pixel hole 2502.

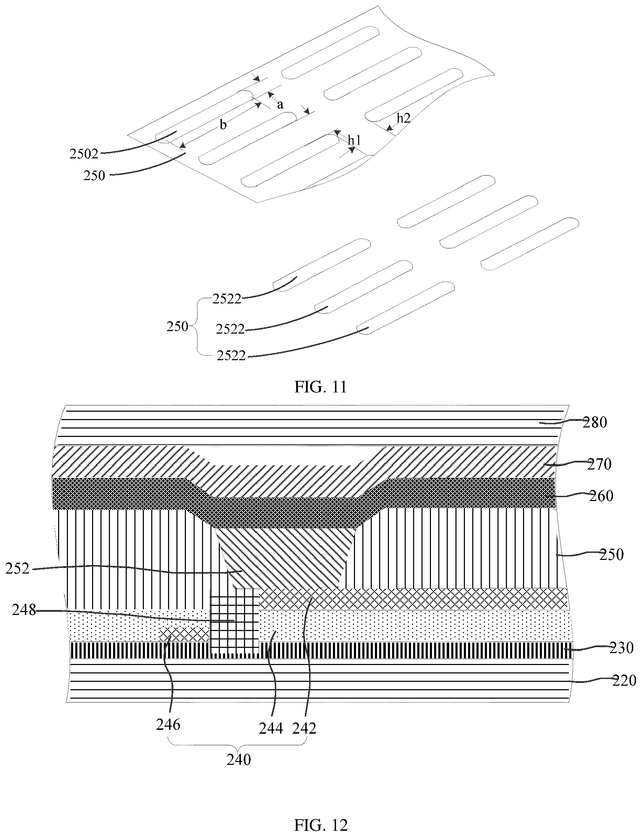

As shown in FIG. 11, in some embodiments, the pixel hole 2502 and the organic light emitter 2522 may both be rectangular with rounded corners. Each of the rectangular pixel hole 2502 and organic light emitter 2522 may have four sharp corners. Therefore, after the light signal passes through the rectangular organic light emitter 2522, a strip-shaped rainbow may be generated due to diffraction. By configuring the pixel hole 2502 and the organic light emitter 2522 with the rounded corners, distortion may be reduced, and the situation of generating the strip-shaped rainbow due to diffraction may be reduced.

The rectangle may include two long sides opposite to each other, and two short sides opposite to each other. The two long sides may be connected via the two short sides. The rectangle with the rounded corners may be the sides being connected by arc-shaped connection lines. That is, each long side may be connected to the short side by an arced connection line. The rectangle having the rounded corners may also be an end of one of the two long sides connected to an end of the other one of the two long sides via an arced connection line, and the other end of one of the two long sides connected to the other end of the other one of the two long sides via an arced connection line. That is, two arced connection lines may replace the two short sides for connecting the two long sides.

In some other embodiments, the pixel hole 2502 and the corresponding organic light emitter 2522 may be configured to be elliptic, polygonal or in other shapes, as long as the pixel hole 2502 and organic light emitter 2522 does not have an acute angle or a right angle. For example, the organic light emitter 2522 may include two long sides opposite and parallel to each other. Two ends of the two long sides may be connected via two connection lines that are connected to each other. An angle between each of the two connection lines and each of the two long sides may be greater than 120 degrees or in any degrees greater than 90 degrees, and an angle between the two connection lines may be greater than 120 degree or in any degrees greater than 90 degrees. Further, a plurality of connection lines may be configured, where ends of the plurality of connection lines may be connected.

It should be noted that, when the pixel hole 2502 and organic light emitter 2522 are not rectangular, the organic light emitter 2522 may include a first side and a second side opposite to each other, and a third side and a fourth side that are opposite to each other and connected to the first side and the second side. The organic light emitter 2522 may be symmetrical. A size of the first side may be equal to a size of the second side, and a size of the third side may be equal to a size of the fourth side. The size of the third side may be greater than the size of the first side. The first size a of the organic light emitter 2522 in the first direction may be understood as a distance between the third and fourth sides, which are parallel to each other, or understood as the size of the first side. The second size b of the organic light emitter 2522 in the second direction may be understood as a distance between the first and second sides, which are parallel to each other, or understood as the size of the third side.

As shown in FIG. 12, in some embodiments, the display apparatus may include a first substrate 220, an anode metal layer 240, a pixel-defining layer 250, a common electrode layer 260, and a second substrate 280, which are disposed in a laminated manner. The pixel-defining layer 250 may be disposed between the anode metal layer 240 and the common electrode layer 260. The anode metal layer 240 and the common electrode layer 260 may drive the organic light emitting layer 252 cooperatively, such that the organic light emitting layer 252 may display various images. The camera module 160 may acquire images through any position of the display apparatus 140. That is, the camera module 160 may acquire the light signals through any position of the display apparatus 140 and generate images based on the light signals.

The first substrate 220 and the second substrate 280 may be colorless and transparent substrates. Specifically, the first substrate 220 and the second substrate 280 may be made of glass, resin and the like. The first substrate 220 and the second substrate 280 may be flexible substrates, and the display apparatus may be a flexible display apparatus.

The anode metal layer 240 may include a first anode metal layer 242, a planarizing layer 244, and a second anode metal layer 246. The first anode metal layer 242 may be disposed between the planarizing layer 244 and the pixel-defining layer 250. The second anode metal layer 246 may be disposed between the planarizing layer 244 and the first substrate 220.

The display apparatus 140 may further include a thin film transistor 248. The thin film transistor 248 may connected to the first anode metal layer 242, the second anode metal layer 246, and the organic light emitting layer 252. The first anode metal layer 242, the second anode metal layer 246, and the organic light emitting layer 252 may be connected to different poles of the thin film transistor 248.

In some embodiments, the first anode metal layer 242 may be disposed between the planarizing layer 244 and the organic light emitting layer 252. The first anode metal layer 242 may be made of nano-silver.

The first anode metal layer 242 may include a plurality of first conductive lines, each of the first conductive lines may extend along the first direction. Each first conductive line may correspond to a portion between two pixel holes 2502. The first anode metal layer 242 may be made of nano-silver. Each first conductive line made of nano-silver may be made narrower or thinner or narrower and thinner if satisfying impedance requirements. In the first direction, the first spacing h1 between the pixel holes 2502 may further be reduced to enable the first spacing h1 to be less than the first size a.

In some embodiments, the display apparatus may include a thin film 230, disposed between the first substrate 220 and the anode metal layer 240. The thin film 230 may be made of SiNx or $SiO_2$.

In some embodiments, the display apparatus may include a capping layer (CPL) 270, disposed between the second substrate 280 and the common electrode layer 260.

It should be noted that, the display apparatus may include the thin film 230 and the capping layer 270, or may not include the thin film 230 and/or the capping layer 270.

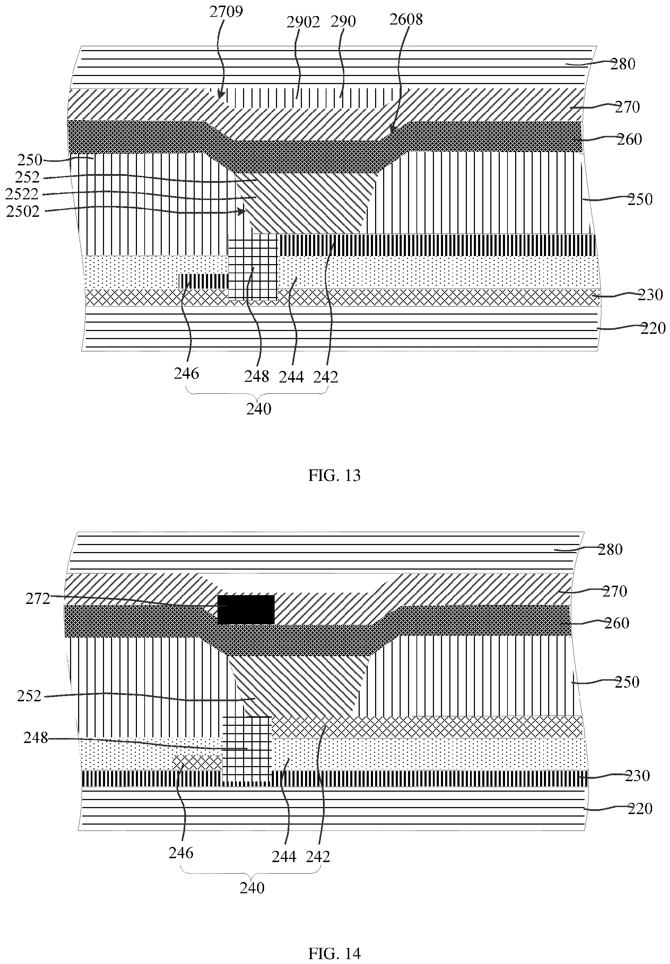

As shown in FIG. 13, in some embodiments, the display apparatus may further include a filling layer 290, disposed on a side of the common electrode layer 260 away from the pixel-defining layer 250. The filling layer 290 may include a plurality of fillers 2902. Each filler 2902 may be configured relative to each pixel hole 2502. A difference between a refractive index of the pixel-defining layer 250 and a refractive index of the filling layer 290 may be less than a difference between the refractive index of the pixel-defining layer 250 and a refractive index of vacuum.

It should be noted that, when the light signal passes through the display apparatus 140, the light signal may pass through a first region of the display apparatus corresponding to the pixel hole 2502 and may have a first path length, and the light signal may pass through a second area of the display apparatus corresponding to a region without the pixel hole and may have a second path length. There may be a difference between the first and the second path lengths. The common electrode layer 260 may cover the organic light emitter 2522 and the pixel-defining layer 250. Thickness of various positions of the common electrode layer 260 may be approximately equal. The common electrode layer 260 may have no effect or limited effect on the path length. As an optical parameter of the pixel-defining layer 250 and an optical parameter of the organic light emitter 2522 may be different, the pixel-defining layer 250 corresponding to the region without the pixel hole and the organic light emitter 2522 corresponding to the pixel hole 2502 may have a greater impact on the path length. In addition, in the related art, due to a process of manufacturing the display apparatus, a gap may be defined in the display apparatus corresponding to the pixel hole 2502, and the gap may be defined on a side of the common electrode layer 260 away from the pixel hole 2502. As no gap is defined relative to the pixel-defining layer 250, the gap may have a great impact on the path length. As the optical parameter of the vacuum in the gap and optical parameter of the pixel-defining layer 250 is great, in this case, in the present embodiment, a filler 2902 may be received in the gap. Further, the difference between the refractive index of the pixel-defining layer 250 and the refractive index of the filling layer 290 may be less than the difference between the refractive index of the pixel-defining layer 250 and the refractive index of the vacuum. Therefore, the difference between the first and the second path lengths may be reduced, such that quality of the image that the camera 160 generates through the display apparatus 140 may be improved.

In detail, in some embodiments, the common electrode layer 260 may define a plurality of second recesses 2608. Openings of the plurality of second recesses 2608 may face the second substrate 280. Each second recess 2608 may be defined relative to each pixel hole 2502. Corresponding to the plurality of second recesses 2608, the capping layer 270 may define a plurality of third recesses 2709. Openings of the plurality of third recesses 2709 may face the second substrate 280. Each of the third recesses 2709 may directly face each pixel hole 2502. Each of the fillers 2902 may be received in one of the third recesses 2709.

Corresponding to the second recess 2608 of the common electrode layer 260, the capping layer 270 may define the third recess 2709, and the filler 2902 may be received in the third recess 2709. In this way, the structure of the original display apparatus 140 may not be significantly affected.

In some embodiments, the display apparatus 140 may have the first path length that is perpendicular to a direction of the first substrate 220 and corresponds to the pixel hole 2502, and the display device 140 may have the second path length that is perpendicular to the direction of the first substrate 220 and corresponds to the region without the pixel hole 2502. The first path length may be equal to the second path length.

The first path length may be understood as a path length of the light signal passing through the display apparatus 140 from the region of the corresponding pixel hole 2502 along the direction perpendicular to the first substrate 220. The first path length may specifically be a sum of a product of a thickness and a refractive index of the second substrate 280, a product of a thickness and a refractive index of the capping layer 270, a product of a thickness and a refractive index of the filling layer 290, a product of a thickness and a refractive index of the common electrode layer 260, a product of a thickness and a refractive index of the organic light emitting layer 252, a product of a thickness and a refractive index of the anode metal layer 240, and a product of a thickness and a refractive index of the first substrate 220.

The second path length may be understood as a path length of the light signal passing through the display apparatus 140 from the region without the pixel hole 2502 along the direction perpendicular to the first substrate 220. The first path length may specifically be a sum of a product of a thickness and a refractive index of the second substrate 280, a product of a thickness and a refractive index of the capping layer 270, a product of a thickness and a refractive index of the common electrode layer 260, a product of a thickness and a refractive index of the pixel-defining layer 250, a product of a thickness and a refractive index of the anode metal layer 240, and a product of a thickness and a refractive index of the first substrate 220.

Each of the second substrate 280, the capping layer 270, the common electrode layer 260, the anode metal layer 240, and the first substrate 220 may cover an entire layer, and the thickness of various positions of each layer may be approximately equal. Therefore, the difference between the first and the second path lengths corresponding to the second substrate 280, the capping layer 270, the common electrode layer 260, the anode metal layer 240, and the first substrate 220 may be neglected.

It should be noted that, the first path length being equal to the second path length may be understood as the first path length being approximately equal to the second path length.

In some embodiments, the filling layer may further include a connector, disposed to cover the common electrode layer and connected to the plurality of fillers.

The fillers may be received in the third recesses, and the connector may cover the entire layer. That is, the connector may cover the entire common electrode layer and the fillers. When the fillers fill the third recesses, two opposite sides of the connector may be parallel.

In some embodiments, each filler may be received in one second recess. The plurality of fillers of the filling layer may be received in the plurality of second recesses of the common electrode layer. The capping layer may cover the filling layer and the common electrode layer. When the fillers fill the second recesses, the capping layer may be configured to lie on the common electrode layer and the filling layer. In some other embodiments, a surface of the filler facing the capping layer may be higher or lower than the common electrode layer. That is, the fillers may not fulfill the second recesses or be higher than the second recesses.

As shown in FIG. 14, in some embodiments, the display apparatus may further include a light shielding block 272, made of a black or dark material. The light shielding block 272 may be configured to block light entering the display apparatus 240. The light shielding block 272 may be configured to correspond to the thin film transistor 248. The light shielding block 272 may be disposed between the organic light emitting layer 252 and the second substrate 280. Each light shielding block 272 may be at least partially opposite to the thin film transistor 248. For example, a projection of the thin film transistor 248 on the first substrate 220 may be located within a projection of the light block 272 on the first substrate 220. In this way, light entering the display apparatus may be prevented from being reflected or refracted by the thin film transistor 248, such that stray light that interferes imaging may be reduced.

In some embodiments, the light shielding block 272 may be arranged in the capping layer 270. For example, a portion of the capping layer 270 corresponding to the thin film transistor 248 may define a through-hole or a recess. The light shielding block 272 may be received in the through-hole or recess correspondingly. An opening of the recess may face the second substrate 280 or the common electrode layer 260.

In some embodiments, the portion of the second substrate 280 corresponding to the thin film transistor 248 may define the recess, and the light shielding block 272 may be received in the recess of the second substrate 280 correspondingly. The opening of the recess of the second substrate 280 may face the common electrode layer 260. In one embodiment, the light shielding block 272 may also be received in the gap between the organic light emitting layer 252 and the common electrode layer 260.

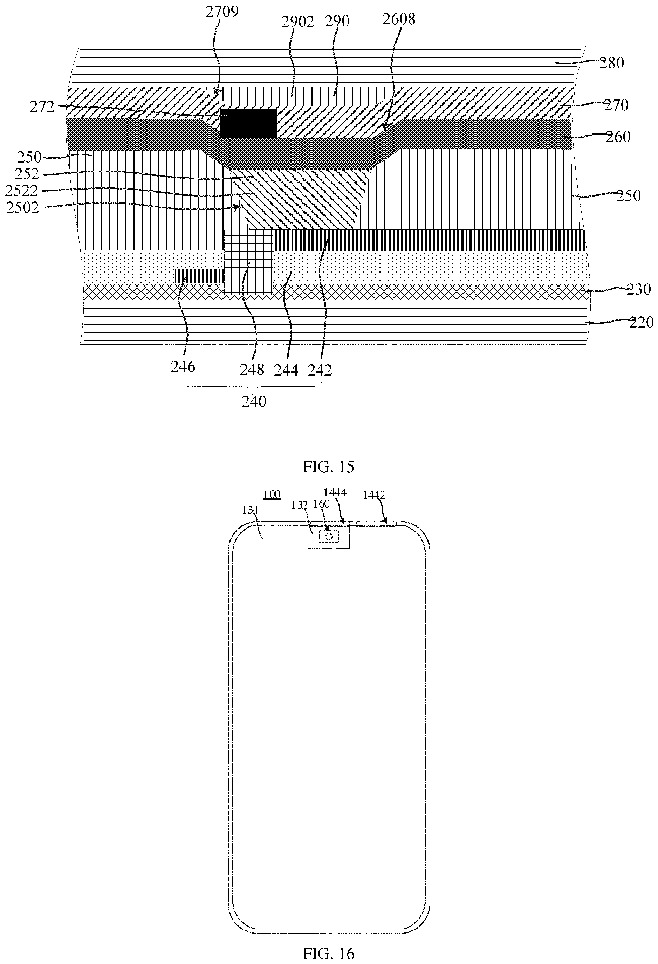

As shown in FIG. 15, the light shielding block 272 may also be arranged in the display apparatus that is provided with the filling layer 290. Detailed structure may be referred to the above embodiment and will not be repeatedly described herein. It should be noted that, in some other embodiments, the light shielding block may also be arranged within the filling layer 290.

In some embodiments, as shown in FIG. 16, the display apparatus 240 may include a transparent region 132 and a body region 134. An area of the transparent region 132 may be less than an area of the body region 134. A light transmittance rate of the transparent region 132 may be greater than a light transmittance rate of the body region 134. The camera module 160 may be opposite to the transparent region 132.

The transparent region 132 may be connected to a first drive module 1444. The body region 134 may be connected to a second drive module 1442. The first drive module 1444 may drive the transparent region 132 of the display apparatus 240. The second drive module 1442 may drive the body region 134 of the display apparatus 240. In this way, the transparent region 132 and the body region 134 may cooperatively display one image. For example, the transparent region 132 may display a part of the image, and the body region 134 may display the rest part of the image. When the camera module 160 needs to acquire an image, the first drive module 1444 may drive the transparent region 132 to deactivate display function, and the second drive module 1442 may still drive the body region 134 to display the image. The camera module 160 may acquire the external light signal through the transparent region 132 that deactivates the display function and may obtain the image based on the acquired light signal.

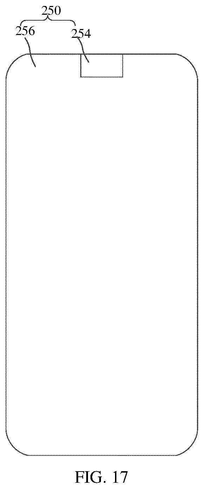

In some embodiments, as shown in FIG. 17, and further referring to FIG. 1 and FIG. 2, the pixel-defining layer 250 may include a first portion 254 and a second portion 256. The first portion 254 may correspond to the transparent region, and the second portion 256 may correspond to the body region. An area of the first portion 254 may be less than an area of the second portion 256. The second portion 256 may also include a plurality of organic light emitters 2522 arranged in an array. The light transmittance rate of the first portion 254 may be greater than the light transmittance rate of the second portion. The camera module 160 may acquire light signals through the first portion 254 of the display apparatus 140 and generate an image based on the light signals.

In some embodiments, the first portion 254 may be disposed at an end portion of the pixel-defining layer 250. In detail, the first portion 254 may be disposed at a top, a bottom or a side edge of the pixel-defining layer 250. For example, when the pixel-defining layer 250 is rectangular, the second portion 256 may be a rectangle having a notch, and the first portion 254 may be received in the notch. The notch may be defined at the top, the bottom or the side edge of the second portion 256. The first portion 254 may also be disposed in a middle of the pixel-defining layer 250. It may be understood as the second portion 256 defining a through hole extending through a thickness direction of the second portion 256, and the first portion 254 being received in the through hole.

Correspondingly, the camera module 160 may be configured corresponding to the first portion. The camera module 160 may obtain the light signal through the first portion 254 of the display apparatus 140. The light transmittance rate of the display device 140 corresponding to the first portion 254 may be greater than the light transmittance rate of the display apparatus 12 corresponding to the second portion. Specifically, distribution density of the organic light emitters 2522 corresponding to the first portion 254 may be less, i.e., less than distribution density of the organic light emitters 2522 corresponding to the second portion 256. The distribution density of the organic light emitters 2522 corresponding to the first portion 254 may be less, and distribution density of the non-transparent thin film transistors 248 that is in one-to-one correspondence to the organic light emitters 2522 may be less, such that the light transmittance rate of the display apparatus 140 corresponding to the first portion may be improved.

In some embodiments, the distribution density of the organic light emitters 2522 of the first portion 254 may be less than the distribution density of the organic light emitters 2522 of the second portion 256. It may be also understood as the spacing between two adjacent pixel holes 2502 of the first portion 254 being greater than the spacing between two adjacent pixel holes 2502 of the second portion 256. The light transmittance rate of the pixel-defining layer 250 may be greater than the light transmittance rate of the organic light emitter 2522. An occupation rate of the organic light emitting layer 252 of the first portion 254 may be less. In this way, the light transmittance rate of the first portion 254 may be greater than the light transmittance rate of the second portion 256. In addition, each organic light emitter 2522 may correspond to one thin film transistor 248, and the thin film transistor 248 is non-transparent. The distribution density of the organic light emitters 2522 of the first portion 254 may be less, and correspondingly, and the distribution density of the thin film transistors 248 may also be less. In this way, the light transmittance rate of the first portion 254 may be greater than the light transmittance rate of the second portion 256.

The transparent region and the body region may be different mainly in the pixel-defining layer. The transparent region and the body region may share a same first substrate, a same second substrate, and the like.

It should be noted that the anode metal layer 240 corresponding to the first portion 254 may be made of a highly light-transmissive material, such as ITO, nano-silver, and the like. The anode metal layer 240 corresponding to the second portion 256 may be made of the highly light-transmissive material, lower light-transmissive material, or non-transparent material.

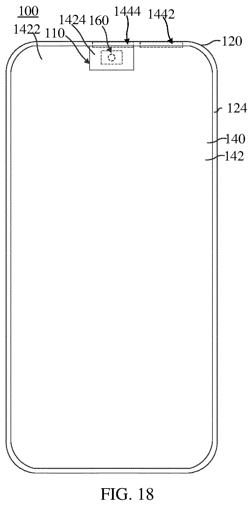

In some embodiments, as shown in FIG. 18, the display apparatus 140 may include a first display panel 1422 and a second display panel 1424. The first display panel 1422 may define a notch 110. The notch 110 may extend through the first display panel 1422 in a thickness direction of the first display panel 1422. The first display panel 1422 may be a display panel 142 for normal display. The second display panel 1424 may be received in the notch 110. The second display panel 1424 may correspond to the transparent region of the display apparatus 240. The first display panel 1422 may correspond to the body region of the display apparatus 240. The camera module 160 of the electronic device 100 may be disposed between the shell and the second display panel 1424. The camera module 160 may acquire the light signal that passes through the transparent region and generate an image based on the acquired light signal.

The first display panel 1422 and the second display panel 1424 may be two separate display panels. The first display panel 1422 and the second display panel 1424 are manufactured separately. Subsequently, the second display panel 1424 may be received in the notch 110 of the first display panel 1422.

It should be noted that, the first display panel 1422 may be connected to the second drive module 1442, and the second display panel 1424 may be connected to the first drive module 1444. The first drive module 1444 may drive the second display panel 1424, and the second drive module 1442 may drive the first display panel 1422. The first drive module 1442 and the second drive module 1444 may cooperatively drive the first display panel 1422 and the second display panel 1424 to cooperatively display one same image. For example, the first display panel 1422 may display a part of the image, and the second display panel 1424 may display the rest part of the image. When the camera module needs to acquire the image, the first driver module 1444 may drive the second display panel 1424 to deactivate the display function, and the second drive module 1442 may still drive the first display panel 1422 to display the image. The camera module may acquire external light signals through the second display panel 1424 which deactivates the display function, and obtain the image based on the light signals.

In some embodiments, an image acquisition surface of the camera module for capturing images may be small, and an area of an individual organic light emitter of the display apparatus may be relatively large. An area of the image acquisition surface of the camera module may be equal to or less than the area of the individual organic light emitter. The camera module may capture images through the organic light emitter.

In some embodiments, the image acquisition surface of the camera module for capturing images may be small, and a spacing between two adjacent organic light emitters in the display apparatus may be large. The area of the image acquisition surface of the camera module may be equal to or less than the spacing. The camera module may capture images through the organic light emitter. The camera module may capture images through the spacing between the two adjacent organic light emitters.

In some embodiments, as shown in FIG. 2, the pixel structure of the present embodiment may include the pixel-defining layer 250 and the organic light emitting layer 252.

The pixel-defining layer 250 may include the plurality of pixel holes 2502 arranged in the array. The first spacing h1 may be present between two adjacent pixel holes 2502 in the first direction, and the second spacing h2 may be present between two adjacent pixel holes 2502 in the second direction.

The organic light emitting layer 252 may include the plurality of organic light emitters 2522. Each organic light emitter 2522 may be received in one pixel hole 2502 correspondingly. Each organic light emitter 2522 may have the first size a in the first direction and the second size b in the second direction.

The first direction may be perpendicular to the second direction. The first size a may not equal to the first spacing h1, and the second size b may not be equal to the second spacing h2.

Although the pixel structure may be a periodic structure, in the first direction, the first size a of the organic emitter 2522 may not be equal to the first spacing h1 between the two adjacent pixel holes 2502. In the second direction, the second size b of the organic light emitter 2522 may not be equal to the second spacing h2 between the two adjacent pixel holes 2502. In this way, the diffraction effect of the light signal that passes through the pixel structure may be reduced.

The plurality of pixel holes 2502 may be defined in an array, and the plurality of pixel holes 2502 in the array may include multiple columns of pixel holes 2502 and multiple rows of pixel holes 2502. The multiple columns may be parallel to each other, and the multiple rows are parallel to each other. The first direction may be understood as the row direction of the array, and the second direction may be understood as the column direction of the array. Alternatively, the first direction may be understood as the column direction of the array, and the second direction may be understood as the row direction of the array.

In some embodiments, the first size a of the organic light emitter 2522 may be less than the second size b of the organic light emitter 2522, and the second size b may not be equal to the first spacing h1.

The organic light emitter 2522 may be strip-shaped, having a short side and a long side. The short side may correspond to the first size a, and the long side may correspond to the second size b. The second side b of the organic light emitter 2522 may not be equal to the first spacing h1. The organic light emitter 2522 may be rectangular or in other shapes.

In some embodiments, the first size a of the organic light emitter 2522 may be less than the first spacing h1, and the second size b may be greater than the first spacing h1.

In the first direction, the first spacing h1 between two adjacent pixel holes 2502 may be greater than the first size a of the organic light emitter 2522. Generally, the sizes of the organic light emitter 2522 may be fixed, and therefore, the spacing between two adjacent pixel holes 2502 may be increased, such that the first size a may be less than the first spacing h1. The second size b of the organic light emitter 2522 may also be greater than the first spacing h1, and the first spacing h1 may be greater than the first size a. It should be understood that the organic light emitter 2522 may be strip-structured, such as in a shape of a rectangle, and the like.

In some embodiments, the first size a of the organic light emitter 2522 may be less than the second size b, and the first size a may be greater than the first spacing h1.

In the first direction, the first size a of the organic emitter 2522 may be greater than the first spacing h1 between two adjacent pixel holes 2502, such that the diffraction effect of the light signal that passes through the pixel structure may be reduced.

In some embodiments, each pixel hole 2502 may be squared, and the organic light emitter 2522 received in the pixel hole 2502 may also be squared. The first size a of the organic light emitter 2522 in the first direction may be equal to the second size b of the organic light emitter in the second direction. In the first direction, the first size a of the organic light emitter may be greater or less than the first spacing h1 between the two adjacent pixel holes. In the second direction, the second size b of the organic light emitter may be greater or less than the second spacing h2 between the two adjacent pixel holes. The first spacing h1 and the second spacing h2 may be equal or unequal. The first spacing h1 may be greater or less than the second spacing h2. In this way, the diffraction effect of the light signal that passes through the pixel structure may be reduced.

It should be noted that, the greater the difference between the first size a of the organic light emitter 2522 and the first spacing h1, the more the diffraction effect of the light signal passing through the pixel structure may be reduced. The larger the difference between the second size b and the second spacing h2, the more the diffraction effect of the light signal passing through the pixel structure may be reduced.

In some embodiments, each pixel hole 2502 may be rectangular, and the organic light emitter 2522 received in the pixel hole 2502 may be rectangular correspondingly. The first direction may be understood as the row direction of the array or a direction parallel to the short side of the pixel hole 2502. The second direction may be understood as the column direction of the array or a direction parallel to the long side of the pixel hole 2502.

In some embodiments, as shown in FIG. 11, the pixel hole 2502 and the organic light emitter 2522 may both be rectangular with rounded corners. Each of the rectangular pixel hole 2502 and organic light emitter 2522 may have four sharp corners. Therefore, after the light signal passes through the rectangular organic light emitter 2522, a strip-shaped rainbow may be generated due to diffraction. By configuring the pixel hole 2502 and the organic light emitter 2522 with the rounded corners, distortion may be reduced, and the case of generating the strip-shaped rainbow due to diffraction may be reduced. The rectangle may include two long sides opposite to each other, and two short sides opposite to each other. The two long sides may be connected via the two short sides. The rectangle with the rounded corners may be the sides being connected by arc-shaped connection lines. That is, each long side may be connected to the short side by an arced connection line. The rectangle having the rounded corners may also be an end of one of the two long sides connected to an end of the other one of the two long sides via an arced connection line, and the other end of one of the two long sides connected to the other end of the other one of the two long sides via an arced connection line. That is, two arced connection lines may replace the two short sides for connecting the two long sides.

In some other embodiments, the pixel hole 2502 and the corresponding organic light emitter 2522 may be configured to be elliptic, polygonal or in other shapes, as long as the pixel hole 2502 and organic light emitter 2522 does not have an acute angle or a right angle. For example, the organic light emitter 2522 may include two long sides opposite and parallel to each other. Two ends of the two long sides may be connected via two connection lines that are connected to each other. An angle between each of the two connection lines and each of the two long sides may be greater than 120 degrees or in any degrees greater than 90 degrees, and an angle between the two connection lines may be greater than 120 degree or in any degrees greater than 90 degrees. Further, a plurality of connection lines may be configured, where ends of the plurality of connection lines may be connected.

It should be noted that, when the pixel hole 2502 and organic light emitter 2522 are not rectangular, the organic light emitter 2522 may include a first side and a second side opposite to each other, and a third side and a fourth side that are opposite to each other and connected to the first side and the second side. The organic light emitter 2522 may be symmetrical. A size of the first side may be equal to a size of the second side, and a size of the third side may be equal to a size of the fourth side. The size of the third side may be greater than the size of the first side. The first size a of the organic light emitter 2522 in the first direction may be understood as a distance between the third and fourth sides, which are parallel to each other, or understood as the size of the first side. The second size b of the organic light emitter 2522 in the second direction may be understood as a distance between the first and second sides, which are parallel to each other, or understood as the size of the third side.

In some embodiments, the pixel hole 2502 and the organic emitter 2522 may be rounded rectangular. The organic emitter 2522 may be rounded rectangular. In this way, distortion may be reduced, and a case of generating the strip-shaped rainbow due to diffraction may be reduced.

In some embodiments, as shown in FIG. 2 and FIG. 17, the display apparatus of the present embodiment may include a pixel-defining layer 250 and an organic light emitting layer 252.

The pixel-defining layer 250 may include a first portion 254. The first portion 254 may define a plurality of pixel holes 2502 arranged in an array. A first spacing h1 may be present between two adjacent pixel holes 2502 in the first direction, and a second spacing h2 may be present between two adjacent pixel holes 2502 in the second direction.

The organic light emitting layer 252 may include a plurality of organic light emitters 2522. Each organic light emitter 2522 may be correspondingly received in one pixel hole 2502. Each organic light emitter 2522 may have a first size a in a first direction and a second size b in the second direction.

The first direction may be perpendicular to the second direction, the first size a may not be equal to the first spacing h1, and the second size b may not be equal to the second spacing h2.

Although the pixel structure may be a periodic structure, in the first direction, the first size a of the organic emitter 2522 may not be equal to the first spacing h1 between the two adjacent pixel holes 2502. In the second direction, the second size b of the organic light emitter 2522 may not be equal to the second spacing h2 between the two adjacent pixel holes 2502. In this way, the diffraction effect of the light signal that passes through the pixel structure may be reduced.

The plurality of pixel holes 2502 may be defined in an array, and the plurality of pixel holes 2502 in the array may include multiple columns of pixel holes 2502 and multiple rows of pixel holes 2502. The multiple columns may be parallel to each other, and the multiple rows are parallel to each other. The first direction may be understood as the row direction of the array, and the second direction may be understood as the column direction of the array. Alternatively, the first direction may be understood as the column direction of the array, and the second direction may be understood as the row direction of the array.

In some embodiments, the first size a of the organic light emitter 2522 may be less than the second size b of the organic light emitter 2522, and the second size b may not be equal to the first spacing h1.

The organic light emitter 2522 may be strip-shaped, having a short side and a long side. The short side may correspond to the first size a, and the long side may correspond to the second size b. The second side b of the organic light emitter 2522 may not be equal to the first spacing h1. The organic light emitter 2522 may be rectangular or in other shapes.

In some embodiments, the first size a of the organic light emitter 2522 may be less than the first spacing h1, and the second size b may be greater than the first spacing h1.

In the first direction, the first spacing h1 between two adjacent pixel holes 2502 may be greater than the first size a of the organic light emitter 2522. Generally, the sizes of the organic light emitter 2522 may be fixed, and therefore, the spacing between two adjacent pixel holes 2502 may be increased, such that the first size a may be less than the first spacing h1. The second size b of the organic light emitter 2522 may also be greater than the first spacing h1, and the first spacing h1 may be greater than the first size a. It should be understood that the organic light emitter 2522 may be strip-structured, such as in a shape of a rectangle, and the like.

In some embodiments, the first size a of the organic light emitter 2522 may be less than the second size b, and the first size a may be greater than the first spacing h1.

In the first direction, the first size a of the organic emitter 2522 may be greater than the first spacing h1 between two adjacent pixel holes 2502, such that the diffraction effect of the light signal that passes through the pixel structure may be reduced.

In some embodiments, as shown in FIG. 12, the display apparatus 140 may further include a planarizing layer 244 and a first anode metal layer 242. The first anode metal layer 242 may be disposed between the planarizing layer 244 and the organic light emitting layer, and may be made of nano-silver.

The first anode metal layer 242 may include a plurality of first conductive lines, each of the first conductive lines may extend along the first direction. Each first conductive line may correspond to a portion between two pixel holes 2502. The first anode metal layer 242 may be made of nano-silver. Each first conductive line made of nano-silver may be made narrower or thinner or narrower and thinner if satisfying impedance requirements. In the first direction, the first spacing h1 between the pixel holes 2502 may further be reduced to enable the first spacing h1 to be less than the first size a.

In some embodiments, each pixel hole 2502 may be squared, and the organic light emitter 2522 received in the pixel hole 2502 may also be squared. The first size a of the organic light emitter 2522 in the first direction may be equal to the second size b of the organic light emitter 2522 in the second direction. In the first direction, the first size a of the organic light emitter 2522 may be greater or less than the first spacing h1 between the two adjacent pixel holes 2502. In the second direction, the second size b of the organic light emitter 2522 may be greater or less than the second spacing h2 between the two adjacent pixel holes 2502. The first spacing h1 and the second spacing h2 may be equal or unequal. The first spacing h1 may be greater or less than the second spacing h2. In this way, the diffraction effect of the light signal that passes through the pixel structure may be reduced.

It should be noted that, the greater the difference between the first size a of the organic light emitter 2522 and the first spacing h1, the more the diffraction effect of the light signal passing through the pixel structure may be reduced. The larger the difference between the second size b and the second spacing h2, the more the diffraction effect of the light signal passing through the pixel structure may be reduced.

In some embodiments, each pixel hole 2502 may be rectangular, and the organic light emitter 2522 received in the pixel hole 2502 may be rectangular correspondingly. The first direction may be understood as the row direction of the array or a direction parallel to the short side of the pixel hole 2502. The second direction may be understood as the column direction of the array or a direction parallel to the long side of the pixel hole 2502.

In some embodiments, as shown in FIG. 11, the pixel hole 2502 and the organic light emitter 2522 may both be rectangular with rounded corners. Each of the rectangular pixel hole 2502 and organic light emitter 2522 may have four sharp corners. Therefore, after the light signal passes through the rectangular organic light emitter 2522, a strip-shaped rainbow may be generated due to diffraction. By configuring the pixel hole 2502 and the organic light emitter 2522 with the rounded corners, distortion may be reduced, and the case of generating the strip-shaped rainbow due to diffraction may be reduced. The rectangle may include two long sides opposite to each other, and two short sides opposite to each other. The two long sides may be connected via the two short sides. The rectangle with the rounded corners may be the sides being connected by arc-shaped connection lines. That is, each long side may be connected to the short side by an arced connection line. The rectangle having the rounded corners may also be an end of one of the two long sides connected to an end of the other one of the two long sides via an arced connection line, and the other end of one of the two long sides connected to the other end of the other one of the two long sides via an arced connection line. That is, two arced connection lines may replace the two short sides for connecting the two long sides.

In some other embodiments, the pixel hole 2502 and the corresponding organic light emitter 2522 may be configured to be elliptic, polygonal or in other shapes, as long as the pixel hole 2502 and organic light emitter 2522 does not have an acute angle or a right angle. For example, the organic light emitter 2522 may include two long sides opposite and parallel to each other. Two ends of the two long sides may be connected via two connection lines that are connected to each other. An angle between each of the two connection lines and each of the two long sides may be greater than 120 degrees or in any degrees greater than 90 degrees, and an angle between the two connection lines may be greater than 120 degree or in any degrees greater than 90 degrees. Further, a plurality of connection lines may be configured, where ends of the plurality of connection lines may be connected.

It should be noted that, when the pixel hole 2502 and organic light emitter 2522 are not rectangular, the organic light emitter 2522 may include a first side and a second side opposite to each other, and a third side and a fourth side that are opposite to each other and connected to the first side and the second side. The organic light emitter 2522 may be symmetrical. A size of the first side may be equal to a size of the second side, and a size of the third side may be equal to a size of the fourth side. The size of the third side may be greater than the size of the first side. The first size a of the organic light emitter 2522 in the first direction may be understood as a distance between the third and fourth sides, which are parallel to each other, or understood as the size of the first side. The second size b of the organic light emitter 2522 in the second direction may be understood as a distance between the first and second sides, which are parallel to each other, or understood as the size of the third side.

In some embodiments, the pixel hole 2502 and the organic emitter 2522 may be rounded rectangular. The organic emitter 2522 may be rounded rectangular. In this way, distortion may be reduced, and a case of generating the strip-shaped rainbow due to diffraction may be reduced.

As shown in FIG. 13, in some embodiments, the display apparatus may further include a filling layer 290, the filling layer 290 is disposed on a side of the common electrode layer 260 away from the pixel-defining layer 250. The filling layer 290 may include a plurality of fillers 2902. Each filler 2902 may be arranged corresponding to one pixel hole 2502. A difference between the refractive index of the pixel-defining layer 250 and the refractive index of the filling layer 290 may be less than a difference between the refractive index of the pixel-defining layer 250 and the refractive index of the vacuum.

In detail, in some embodiments, the common electrode layer 260 may define a plurality of second recesses 2608. Openings of the plurality of second recesses 2608 may face the second substrate 280. Each second recess 2608 may be defined corresponding to each pixel hole 2502. Corresponding to the plurality of second recesses 2608, the capping layer 270 may define a plurality of third recesses 2709. Openings of the plurality of third recesses 2709 may face the second substrate 280. Each of the third recesses 2709 may directly face each pixel hole 2502. Each of the fillers 2902 may be received in one of the third recesses 2709.

In some embodiments, each filler may be received in one second recess. The plurality of fillers of the filling layer may be received in the plurality of second recesses of the common electrode layer. The capping layer may cover the filling layer and the common electrode layer. When the fillers fill the second recesses, the capping layer may be configured to lie on the common electrode layer and the filling layer. In some other embodiments, a surface of the filler facing the capping layer may be higher or lower than the common electrode layer. That is, the fillers may not fulfill the second recesses or be higher than the second recesses.

In some embodiments, as shown in FIG. 14, the display apparatus may further include a light shielding block 272, made of a black or dark material. The light shielding block 272 may be configured to block light entering the display apparatus 240. The light shielding block 272 may be configured to correspond to the thin film transistor 248. The light shielding block 272 may be disposed between the organic light emitting layer 252 and the second substrate 280. A projection of the thin film transistor 248 on the first substrate 220 may be located within a projection of the light block 272 on the first substrate 220. In this way, light entering the display apparatus may be prevented from being reflected or refracted by the thin film transistor 248, such that stray light that interferes imaging may be reduced. In detail, the light shielding block 272 may be arranged in the capping layer 270. For example, a portion of the capping layer 270 corresponding to the thin film transistor 248 may define a through-hole or a recess. The light shielding block 272 may be received in the through-hole or recess correspondingly. An opening of the recess may face the second substrate 280 or the common electrode layer 260. In some embodiments, the portion of the second substrate 280 corresponding to the thin film transistor 248 may define the recess, and the light shielding block 272 may be received in the recess of the second substrate 280 correspondingly. The opening of the recess of the second substrate 280 may face the common electrode layer 260. In one embodiment, the light shielding block 272 may also be received in the gap between the organic light emitting layer 252 and the common electrode layer 260.

As shown in FIG. 15, the light shielding block 272 may also be arranged in the display apparatus that is provided with the filling layer 290. Detailed structure may be referred to the above embodiment and will not be repeatedly described herein. It should be noted that, in some other embodiments, the light shielding block may also be arranged within the filling layer 290.

In some embodiments, as shown in FIG. 16, the display apparatus 240 may include a transparent region 132 and a body region 134. An area of the transparent region 132 may be less than an area of the body region 134. A light transmittance rate of the transparent region 132 may be greater than a light transmittance rate of the body region 134. The camera module 160 may be opposite to the transparent region 132.

The transparent region 132 may be connected to a first drive module 1444. The body region 134 may be connected to a second drive module 1442. The first drive module 1444 may drive the transparent region 132 of the display apparatus 240. The second drive module 1442 may drive the body region 134 of the display apparatus 240. In this way, the transparent region 132 and the body region 134 may cooperatively display one image. For example, the transparent region 132 may display a part of the image, and the body region 134 may display the rest part of the image. When the camera module 160 needs to acquire an image, the first drive module 1444 may drive the transparent region 132 to deactivate the display function, and the second drive module 1442 may still drive the body region 134 to display the image. The camera module 160 may acquire the external light signal through the transparent region 132 that deactivates the display function and may obtain the image based on the acquired light signal.

In some embodiments, as shown in FIG. 17, the pixel-defining layer 250 may include a first portion 254 and a second portion 256. An area of the first portion 254 may be less than an area of the second portion 256. The second portion 256 may also include a plurality of organic light emitters 2522 arranged in an array. The light transmittance rate of the first portion 254 may be greater than the light transmittance rate of the body region 256. The pixel structure of the first portion 254 may be referred to the pixel structure of the first portion 254 as described in any one of the above embodiments. Correspondingly, the camera module 160 may acquire light signals through the first portion 254 of the display apparatus 140 and generate an image based on the light signals.

The first portion 254 may be disposed at an end portion of the pixel-defining layer 250. In detail, the first portion 254 may be disposed at a top, a bottom or a side edge of the pixel-defining layer 250. For example, when the pixel-defining layer 250 is rectangular, the second portion 256 may be a rectangle having a notch, and the first portion 254 may be received in the notch. The notch may be defined at the top, the bottom or the side edge of the second portion 256. The first portion 254 may also be disposed in a middle of the pixel-defining layer 250. It may be understood as the second portion 256 defining a through hole extending through a thickness direction of the second portion 256, and the first portion 254 being received in the through hole.

Correspondingly, the camera module 160 may be configured corresponding to the first portion 254. The camera module 160 may obtain the light signal through the first portion 254 of the display apparatus 140. The light transmittance rate of the display device 140 corresponding to the first portion 254 may be greater than the light transmittance rate of the display apparatus 12 corresponding to the second portion. Specifically, distribution density of the organic light emitters 2522 corresponding to the first portion 254 may be less, i.e., less than distribution density of the organic light emitters 2522 corresponding to the second portion 256. The distribution density of the organic light emitters 2522 corresponding to the first portion 254 may be less, and distribution density of the non-transparent thin film transistors 248 that is in one-to-one correspondence to the organic light emitters 2522 may be less, such that the light transmittance rate of the display apparatus 140 corresponding to the first portion may be improved.

In some embodiments, the distribution density of the organic light emitters 2522 of the first portion 254 may be less than the distribution density of the organic light emitters 2522 of the second portion 256. It may be also understood as the spacing between two adjacent pixel holes 2502 of the first portion 254 being greater than the spacing between two adjacent pixel holes 2502 of the second portion 256. The light transmittance rate of the pixel-defining layer 250 may be greater than the light transmittance rate of the organic light emitter 2522. An occupation rate of the organic light emitting layer 252 of the first portion 254 may be less. In this way, the light transmittance rate of the first portion 254 may be greater than the light transmittance rate of the second portion 256. In addition, each organic light emitter 2522 may correspond to one thin film transistor 248, and the thin film transistor 248 is non-transparent. The distribution density of the organic light emitters 2522 of the first portion 254 may be less, and correspondingly, and the distribution density of the thin film transistors 248 may also be less. In this way, the light transmittance rate of the first portion 254 may be greater than the light transmittance rate of the second portion 256.

It should be noted that the anode metal layer 240 corresponding to the first portion 254 may be made of a highly light-transmissive material, such as ITO, nano-silver, and the like. The anode metal layer 240 corresponding to the second portion 256 may be made of the highly light-transmissive material, lower light-transmissive material, or non-transparent material.

In some embodiments, a third spacing may be present between two adjacent organic light emitters 2522 in the first direction of the second portion 256, and the first size may be similar or equal to the third spacing.

In some embodiments, as shown in FIG. 18, the display apparatus 140 may include a first display panel 1422 and a second display panel 1424. The first display panel 1422 may define a notch 110. The notch 110 may extend through the first display panel 1422 in a thickness direction of the first display panel 1422. The first display panel 1422 may be a display panel 142 for normal display. The second display panel 1424 may be received in the notch 110. The camera module 160 of the electronic device 100 may be disposed between the shell 120 and the second display panel 1424. The camera module 160 may acquire the light signal that passes through the transparent region and generate an image based on the acquired light signal.

The first display panel 1422 and the second display panel 1424 may be two separate display panels. The first display panel 1422 and the second display panel 1424 are manufactured separately. Subsequently, the second display panel 1424 may be received in the notch 110 of the first display panel 1422.

The first display panel 1422 may define at least one notch 110. The notch 110 may extend through the first display panel 1422 in the thickness direction of the first display panel 1422. The second display panel 1424 may be received in the notch 110. The first display panel 1422 and the second display panel 1424 may be configured to display images towards a same direction.

In some embodiments, the notch 110 may be regularly shaped such as rectangular, circular, and the like. Alternatively, the notch 110 may also be irregularly shaped.

The first display panel 1422 and the second display panel 1424 of the electronic device 100 may display the same image at the same time, and the first display panel 1422 and the second display panel 1424 may also display different images at the same time.

The notch 110 may be defined in a side edge of the first display panel 1422, or the defined in the middle of the first display panel 1422.

It should be noted that, the first display panel 1422 may be connected to the second drive module 1442, and the second display panel 1424 may be connected to the first drive module 1444. The first drive module 1444 may drive the second display panel 1424, and the second drive module 1442 may drive the first display panel 1422. The first drive module 1442 and the second drive module 1444 may cooperatively drive the first display panel 1422 and the second display panel 1424 to cooperatively display one same image. For example, the first display panel 1422 may display a part of the image, and the second display panel 1424 may display the rest part of the image. When the camera module needs to acquire the image, the first driver module 1444 may drive the second display panel 1424 to deactivate the display function, and the second drive module 1442 may still drive the first display panel 1422 to display the image. The camera module may acquire external light signals through the second display panel 1424 which deactivates the display function, and obtain the image based on the light signals.

In some embodiments, the first display panel and/or the second display panel may be a touchscreen display incorporating a conductive capacitive touch sensor electrode layer or other touch sensor components (e.g., components of a resistive touch sensor, components of an acoustic touch sensor, components of a force-based touch sensor, components of a light-based touch sensor, and the like), or may be a non-touch display. A capacitive touch screen electrode may be formed by an array of indium tin oxide pads or other transparent conductive structures.

The shell 120 of the electronic device 100 may be made of plastic, glass, ceramic, fiber composite, metal (such as stainless steel, aluminum, and the like), other suitable materials, or a combination of any two or more of the above materials. The shell 120 may be configured as an integral overall structure. In the integral overall structure, a part or all of the shell 120 may be processed or molded into a single structure. Alternatively, the shell 120 may be formed by a plurality of structures (such as an inner frame structure, one or more structures forming an outer shell surface, and the like). In some embodiments, the shell 120 may form the entirety of the electronic device 100.

The display apparatus may be configured on a side of the shell. The display apparatus and the shell may define a storage space. The storage space defined between the display apparatus and the shell may receive elements of the electronic device, such as the camera module, a main board, and so on. The main board may be electrically connected to the first drive module, the second drive module and the camera module.

The above provides detailed description of the electronic device, the pixel structure and the display apparatus of the embodiments of the present disclosure. Specific examples are applied to illustrate the principle and implementation of the present disclosure, and the above description of embodiments is only used to facilitate understanding of the present disclosure. At the same time, for any skilled person in the art, based on the concept of the present disclosure, changes may be performed in the specific implementation and the scope for application. In summary, the content of the present specification should not be understood as a limitation of the present disclosure.

**Claims**

1. An electronic device, comprising a display apparatus and a camera module, the display apparatus comprising:

   a pixel-defining layer, defining a plurality of pixel holes arranged in an array, wherein a first spacing is defined between two adjacent pixel holes of the plurality of pixel holes along a first direction, and a second spacing is defined between two adjacent pixel holes of the plurality of pixel holes along a second direction;
   an organic light emitting layer, comprising a plurality of organic light emitters, wherein each of the plurality of organic light emitters is received in one of the plurality of pixel holes, each of the plurality of organic light emitters has a first size in the first direction and a second size in the second direction;
   wherein the first direction is perpendicular to the second direction, the first size is different from the first spacing, and the second size is different from the second spacing;
   at least a part of the camera module is disposed opposite to the pixel holes, and the camera module is configured to capture images through the display apparatus.

2. The electronic device according to claim 1, wherein the first size is less than the second size, and the second size is different from the first spacing.

3. The electronic device according to claim 2, wherein the first size is less than the first spacing, and the second size is greater than the first spacing.

4. The electronic device according to claim 2, wherein the first size is greater than the first spacing.

5. The electronic device according to claim 4, wherein the display apparatus further comprises a planarizing layer and a first anode metal layer, the first anode metal layer is disposed between the planarizing layer and the organic light emitting layer, and the first anode metal layer is made of nano-silver.

6. The electronic device according to claim 1, wherein each of the plurality of pixel holes is rounded rectangular, and each of the plurality of organic light emitters is rounded rectangular.

7. The electronic device according to claim 1, wherein the display apparatus comprises a transparent region and a body region, an area of the transparent region is less than an area of the body region, a light transmittance rate of the transparent region is greater than a light transmittance rate of the body region, the camera module is disposed to face the transparent region.

8. The electronic device according to claim 7, wherein the display apparatus further comprises a first substrate, an anode metal layer, a common electrode layer, and a second substrate, which are disposed in a laminated manner; the pixel-defining layer is disposed between the anode metal layer and the common electrode layer, the pixel-defining layer comprises a first portion and a second portion, the first portion corresponds to the transparent region, and the second portion corresponds to the body region.

9. The electronic device according to claim 7, wherein the display apparatus further comprises a first display panel and a second display panel;

the first display panel defines a notch, the notch extends through the first display panel along a thickness direction of the first display panel;
the second display panel is received in the notch; and
the body region corresponds to the first display panel, the transparent region corresponds to the second display panel.

10. The electronic device according to claim 7, further comprising a processor, wherein

the display apparatus and the camera module are electrically connected to the processor;
the processor is configured to control the transparent region to deactivate a display function and control the camera module to capture an image through the transparent region, in response to an image capturing instruction being received; and
the processor is configured to control the transparent region and the body region to cooperatively display the image in response to the image capturing instruction being not received and an image display instruction being received.

11. A pixel structure, comprising:

a pixel-defining layer, defining a plurality of pixel holes arranged in an array, wherein a first spacing is defined between two adjacent pixel holes of the plurality of pixel holes along a first direction, and a second spacing is defined between two adjacent pixel holes of the plurality of pixel holes along a second direction;
an organic light emitting layer, comprising a plurality of organic light emitters, wherein each of the plurality of organic light emitters is received in one of the plurality of pixel holes, each of the plurality of organic light emitters has a first size in the first direction and a second size in the second direction;
wherein the first direction is perpendicular to the second direction, the first size is different from the first spacing, and the second size is different from the second spacing.

12. The pixel structure according to claim 11, wherein the first size is less than the second size, and the second size is different from the first spacing.

13. The pixel structure according to claim 12, wherein the first size is less than the first spacing, and the second size is greater than the first spacing.

14. The pixel structure according to claim 12, wherein the first size is greater than the first spacing.

15. The pixel structure according to claim 11, wherein each of the plurality of pixel holes is rounded rectangular, and each of the plurality of organic light emitters is rounded rectangular.

16. A display apparatus, comprising:

a pixel-defining layer, defining a plurality of pixel holes arranged in an array, wherein a first spacing is defined between two adjacent pixel holes of the plurality of pixel holes along a first direction, and a second spacing is defined between two adjacent pixel holes of the plurality of pixel holes along a second direction;
an organic light emitting layer, comprising a plurality of organic light emitters, wherein each of the plurality of organic light emitters is received in one of the plurality of pixel holes, each of the plurality of organic light emitters has a first size in the first direction and a second size in the second direction;
wherein the first direction is perpendicular to the second direction, the first size is different from the first spacing, and the second size is different from the second spacing.

17. The display apparatus according to claim 16, wherein the first size is less than the second size, and the second size is different from the first spacing.

18. The display apparatus according to claim 17, wherein the first size is less than the first spacing, and the second size is greater than the first spacing.

19. The display apparatus according to claim 17, wherein the first size is greater than the first spacing.

20. The display apparatus according to claim 19, further comprising a planarizing layer and a first anode metal layer, wherein the first anode metal layer is disposed between the planarizing layer and the organic light emitting layer, and the first anode metal layer is made of nano-silver.

21. The display apparatus according to claim 16, wherein each of the plurality of pixel holes is rounded rectangular, and each of the plurality of organic light emitters is rounded rectangular.

22. The display apparatus according to claim 17, further comprising a transparent region and a body region, wherein an area of the transparent region is less than an area of the body region, a light transmittance rate of the transparent region is greater than a light transmittance rate of the body region, the camera module is disposed to face the transparent region.

23. The display apparatus according to claim 17, further comprising a first substrate, an anode metal layer, a common electrode layer, and a second substrate, which are disposed in a laminated manner;
wherein the pixel-defining layer is disposed between the anode metal layer and the common electrode layer, the pixel-defining layer comprises a first portion and a second portion, the first portion corresponds to the transparent region, and the second portion corresponds to the body region.

24. A display apparatus, comprising a first display panel and a second panel, wherein

the first display panel defines a notch, the notch extends through the first display panel along a thickness direction of the first display panel;
the second display panel is received in the notch;
a pixel structure of the second display panel comprises:

a pixel-defining layer, defining a plurality of pixel holes arranged in an array, wherein a first spacing is defined between two adjacent pixel holes of the plurality of pixel holes along a first direction, and a second spacing is defined between two adjacent pixel holes of the plurality of pixel holes along a second direction;
an organic light emitting layer, comprising a plurality of organic light emitters, wherein each of the plurality of organic light emitters is received in one of the plurality of pixel holes, each of the plurality of organic light emitters has a first size in the first direction and a second size in the second direction;
wherein the first direction is perpendicular to the second direction, the first size is different from the first spacing, and the second size is different from the second spacing.

FIG. 1

FIG. 2

FIG. 3

Far-field diffraction light intensity

FIG. 4

Envelope of Far-field diffraction light intensity

FIG. 5

## Comb function

FIG. 6

## Far-field diffraction light intensity of light spot

FIG. 7

a=18μm,d=23μm

FIG. 8a

FIG. 8b

FIG. 8c

FIG. 8d

FIG. 8e

a=18μm,d=73μm

FIG. 8f

a=18μm,d=83μm

FIG. 8g

a=18μm,d=93μm

FIG. 8h

a=18μm,d=103μm

FIG. 8i

a=18μm,d=150μm

FIG. 8j

a=18μm,d=200μm

FIG. 8k

a=3μm,d=43μm

FIG. 9a

a=8μm,d=43μm

FIG. 9b

a=13μm,d=43μm

FIG. 9c

a=18μm,d=43μm

FIG. 9d

a=23μm,d=43μm

FIG. 9e

a=28μm,d=43μm

FIG. 9f

a=33μm,d=43μm

FIG. 9g

a=38μm,d=43μm

FIG. 9h

FIG. 10

2502

250

2522

250 { 2522

2522

b

a

h1

h2

FIG. 11

280

270

260

250

252

248

230

220

246

244 242

240

FIG. 12

2709    2902   290     2608

280

270

260

250
252
2522
2502

250

230

220

246     248   244   242

240

FIG. 13

280

272

270

260

250

252

248

230

220

246      244   242

240

FIG. 14

2709 2902 290 2608

280

272

270

260

250
252
2522
2502

250

230

220

246 248 244 242

240

FIG. 15

100
134 132 160 1444 1442

FIG. 16

FIG. 17

FIG. 18

## INTERNATIONAL SEARCH REPORT

| International application No. |
| --- |
| **PCT/CN2020/073149** |

**A. CLASSIFICATION OF SUBJECT MATTER**

H01L 27/32(2006.01)i; G09F 9/33(2006.01)i

According to International Patent Classification (IPC) or to both national classification and IPC

**B. FIELDS SEARCHED**

Minimum documentation searched (classification system followed by classification symbols)

H01L G09F

Documentation searched other than minimum documentation to the extent that such documents are included in the fields searched

Electronic data base consulted during the international search (name of data base and, where practicable, search terms used)

CNABS; CNTXT; CNKI; SIPOABS; DWPI; USTXT; WOTXT; EPTXT: 像素定义, 间距, 宽度, 摄像, 衍射, 开口, 阵列, pixel defin+, spac+, width, camera, diffract+, opening, array

**C. DOCUMENTS CONSIDERED TO BE RELEVANT**

| Category* | Citation of document, with indication, where appropriate, of the relevant passages | Relevant to claim No. |
| --- | --- | --- |
| X | CN 105047092 A (EVERDISPLAY OPTRONICS (SHANGHAI) LIMITED) 11 November 2015 (2015-11-11) description, paragraphs [0035]-[0045], and figures 4(a) and 4(b) | 11-21 |
| A | CN 105047092 A (EVERDISPLAY OPTRONICS (SHANGHAI) LIMITED) 11 November 2015 (2015-11-11) description, paragraphs [0035]-[0045], and figures 4(a) and 4(b) | 1-10, 22-24 |
| A | KR 20090021714 A (LG ELECTRONICS INC.) 04 March 2009 (2009-03-04) entire document | 1-24 |
| A | CN 108074950 A (LG DISPLAY CO., LTD.) 25 May 2018 (2018-05-25) entire document | 1-24 |
| A | CN 109271829 A (GINGY TECHNOLOGY CO., LTD.) 25 January 2019 (2019-01-25) entire document | 1-24 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **02 March 2020** | **08 April 2020** |

| Name and mailing address of the ISA/CN | Authorized officer |
| --- | --- |
| **China National Intellectual Property Administration (ISA/CN)** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

# EP 3 916 790 A1

## INTERNATIONAL SEARCH REPORT
### Information on patent family members

International application No.

**PCT/CN2020/073149**

| Patent document cited in search report | | | Publication date (day/month/year) | Patent family member(s) | | | Publication date (day/month/year) |
|---|---|---|---|---|---|---|---|
| CN | 105047092 | A | 11 November 2015 | US | 2017039923 | A1 | 09 February 2017 |
| | | | | CN | 105047092 | B | 06 July 2018 |
| KR | 20090021714 | A | 04 March 2009 | KR | 20090021713 | A | 04 March 2009 |
| | | | | US | 2009058271 | A1 | 05 March 2009 |
| CN | 108074950 | A | 25 May 2018 | KR | 20180053220 | A | 21 May 2018 |
| | | | | US | 2018138255 | A1 | 17 May 2018 |
| | | | | EP | 3321985 | A1 | 16 May 2018 |
| CN | 109271829 | A | 25 January 2019 | US | 2018175125 | A1 | 21 June 2018 |
| | | | | US | 10056439 | B2 | 21 August 2018 |

Form PCT/ISA/210 (patent family annex) (January 2015)

**EP 3 916 790 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910107751